# EUROPEAN PATENT APPLICATION

(11) **EP 4 718 481 A1**
(43) Date of publication of application: **01.04.2026**
(21) Application number: 25202253.8
(22) Date of filing: 15.09.2025
(51) Int. Cl.: H01F 27/02, H01F 38/30, G01R 31/62, H01F 27/36

(54) **MITIGATION OF DIFFERENTIAL CURRENT TRANSFORMER CROSS-TALK**

(30) Priority: 30.09.2024 US 202418902319
(71) Applicant: Schneider Electric USA, Inc., Andover, MA 01810 (US)
(72) Inventor: MELECIO RAMIREZ, Juan Ignacio, North Liberty, IA (US); FISCHELS, Collin Richard, Independence, IA (US); RENDON HERNANDEZ, Adrian Abdala, Grenoble (FR)
(74) Representative: Manitz Finsterwald Patent- und Rechtsanwaltspartnerschaft mbB

(57) **Abstract**

A shielded current transformer having a magnetically permeable shield. The shield includes a magnetically permeable cup-shaped shell that is sized and shaped to receive a core and windings of a current transformer and a magnetically permeable washer-shaped cap for closing the cup-shaped shell. The shield is configured to shield the core from magnetic field lines generated external to the shield.

## Description

### BACKGROUND

This disclosure relates to electrical protective devices employing differential sensors such as current transformers. More specifically, this disclosure relates to apparatuses, systems, and methods for improving performance and reliability of current transformers.

Differential protection works on the principle of Kirchhoff's current law, it states that the total sum of current flowing into a node is zero. If the primary side current is equal to secondary side current, then current law is verified, and no fault is present in the transformer.

A conventional current transformer (CT) for determining ground faults can have uneven coils and experience asymmetric magnetic coupling to the relative location of the two or more conductors passing through its core. This asymmetry can result in false indications as to whether there is a ground fault, for example, because a current is induced in the CT even though the current on the two lines can be substantially the same and should theoretically cancel out. Thus, an induced current on the CT sense coil can falsely indicate that there is a ground fault, even when there is not actually a current mismatch between conductors.

Conventional systems utilize complex and costly device manufacturing and component testing processes. For example, individual electronic components of a device might not be tested until the device is fully assembled, thereby creating high rates of inspection failure for assembled devices. Further, there can be high levels of inconsistency for ground fault detection for high winding asymmetry under handle rated load conditions using existing testing systems. Costs and timing associated with testing circuit breaker sensors and assembled circuit breaker devices is significantly increased by operations and costs associated with reworking and scrapping devices and components based upon test failures only detected at the end of a manufacturing process.

Commonly assigned U.S. Patent Application No. 18/539,141 discloses a sensor for screening a device under test. The sensor includes a body having a plurality of conductors, a rotation section, a probe associated with the rotation section, the probe configured to house at least a portion of one or more of the plurality of conductors, and a nest having at least one terminal, the nest configured to couple to the device under test and to permit at least a portion of the probe to pass through an opening of the device under test.

Commonly assigned U.S. Patent Application No. 18/125,116 discloses a current transformer for a ground fault circuit interrupter (GFCI) including a core having a closed loop shape having a first side, a second side, and a core opening, and a sense coil wrapped around the core configured to magnetically couple to a plurality of conductors passing through the core opening. The current transformer also includes a first magnetic shield disposed on the first side of the core over the sense coil, and a second magnetic shield disposed on a second side of the core over the sense coil.

Challenges on the assembly of breakers and the like having advanced functions can impact the sensor performance. For example, if the current path is in proximity to the sensor assembly, the current creates an electromagnetic pattern that unbalances the output voltage during a loaded ground fault event (load current + ground fault). As a result, sensor output voltage values at specific ground faults deviate from the calibrated ones.

Such conventional methods and systems have generally been considered satisfactory for their intended purpose. However, there is still a need in the art for improvements. This disclosure provides a solution for this need.

### SUMMARY

Aspects of the present disclosure reduce cross-talk from nearby conductors, which reduces its impact on the output voltage of a differential sensor, such as a current transformer, at calibrated ground fault current values. A metallic shield with the shape of a shell protects the differential sensor against unwanted near magnetic fields to reduce cross-talk electromagnetic effects. In addition, the shield design integrates a dual-purpose eyelet.

In an aspect, a shielded current transformer comprises a core having a passage through it configured to receive one or more conductors. The current transformer also includes a sense winding and a test winding each wound around the core. The sense winding is configured to magnetically couple to the conductors passing through the core passage and to generate a fault signal in response to a ground fault condition in the conductors. The test winding is configured to generate a test signal in response to a test signal stimulus applied to the test winding such that the test signal is magnetically coupled to the sense winding. The current transformer further comprises a magnetically permeable shield receiving the core and the windings therein and configured to shield the core from magnetic field lines generated external to the shield.

In another aspect, a shield for a current transformer comprises a magnetically permeable cup-shaped shell sized and shaped to receive a core and windings of a current transformer and a magnetically permeable washer-shaped cap for closing the cup-shaped shell.

In yet another aspect, an electrical protective device comprises a line conductor, a neutral conductor, and a current transformer. The current transformer comprises a core having a passage through it configured to receive the line conductor and the neutral conductor. The current transformer also includes a sense winding and a test winding each wound around the core. The sense winding is configured to magnetically couple to the line conductor and the neutral conductor passing through the core passage and to generate a fault signal in response to a line-to-ground fault condition in the conductors. The test winding is configured to generate a test signal in response to a test signal stimulus applied to the test winding such that the test signal is magnetically coupled to the sense winding. The current transformer further comprises a magnetically permeable shield receiving the core and the windings therein and configured to shield the core from magnetic field lines generated external to the shield.

Other objects and features of the present invention will be in part apparent and in part pointed out herein.

### BRIEF DESCRIPTION OF THE DRAWINGS

FIG. 1 is a perspective view of a current transformer in accordance with an embodiment.
FIG. 2 is a perspective view of a ground fault circuit interrupter having a current transformer disposed therein in accordance with an embodiment.
FIG. 3 is a perspective view of a current transformer having conductors passing through a core opening in accordance with an embodiment.
FIG. 4A illustrates a shielded current transformer assembly having a cap removed to reveal the interior of the assembly in accordance with an embodiment
FIG. 4B is a cross-sectional view of a shielded current transformer in accordance with an embodiment.
FIGS. 5A to 5E illustrate components of a metallic shield for use with a current transformer in accordance with an embodiment.
FIGS. 6A to 6E illustrate components of a metallic shield for use with a current transformer in accordance with another embodiment.
FIGS. 7A and 7B illustrate components of a metallic shield for use with a current transformer in accordance with yet another embodiment.
FIG. 8 is a diagram of flux lines as smoothed by an eyelet of a metallic shield in accordance with an embodiment.
FIGS. 9A and 9B illustrate a test system for screening a device under test in accordance with an embodiment.
FIG. 10 is a schematic diagram of an exemplary test setup in accordance with an embodiment.
FIGS. 11A to 11D illustrate a sequence of testing a device under test through a plurality of radial positions in accordance with an embodiment.
FIG. 12 is a flow diagram illustrating an exemplary process for screening a device under test.
FIGS. 13A and 13B are schematic diagrams of exemplary test setups in accordance with embodiments.
FIG. 14 is a perspective view of an assembly guide for a current transformer in accordance with an embodiment.
FIGS. 15A and 15B illustrate examples of wound cores in accordance with an embodiment.
FIG. 16 is a perspective view of a snap fit housing for a current transformer in accordance with an embodiment.
FIG. 17 is a perspective view of a prong of an assembly guide for positioning conductors passing through a core opening of a current transformer in accordance with an embodiment.
FIGS. 18A to 18C illustrate a core of a current transformer positioned on a prong of an assembly guide in accordance with an embodiment.

Corresponding reference characters indicate corresponding parts throughout the drawings.

### DETAILED DESCRIPTION

The features and other details of the concepts, systems, and techniques sought to be protected herein will now be more particularly described. It will be understood that any specific embodiments described herein are shown by way of illustration and not as limitations of the disclosure and the concepts described herein. Features of the subject matter described herein can be employed in various embodiments without departing from the scope of the concepts sought to be protected.

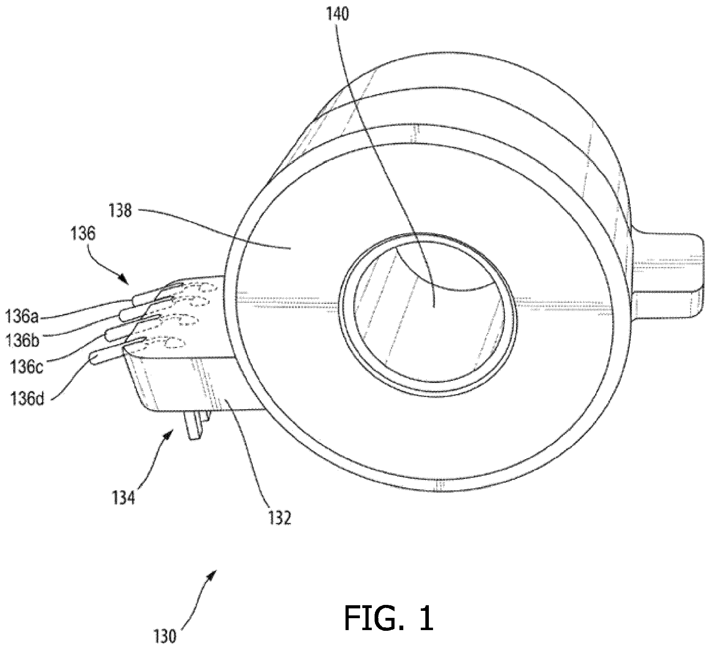

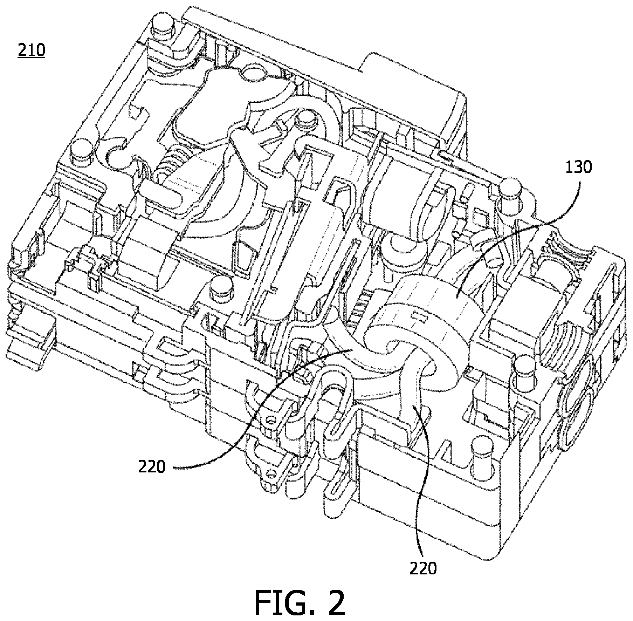

FIG. 1 illustrates an embodiment of a current transformer (CT) 130 according to aspects of this disclosure for use in an electrical protective device 210 (see FIG. 2). The device may be a device or portion thereof configured to perform at least one operation, including a Miniature Circuit Breaker (MCB), a Ground Fault Circuit Interrupter (GFCI), or other electronic device or portion thereof in various embodiments or may be a device or portion of device configured to perform one or more operations corresponding to a GFCI. The CT 130 can be any suitable shape (e.g., a polygonal closed shape, e.g., a rectangular closed shape). For example, CT 130 can be a circular or toroidal closed shapes as shown.

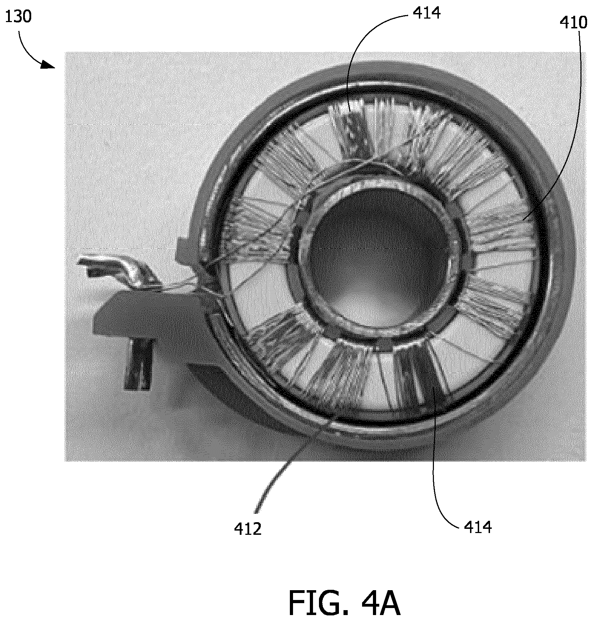

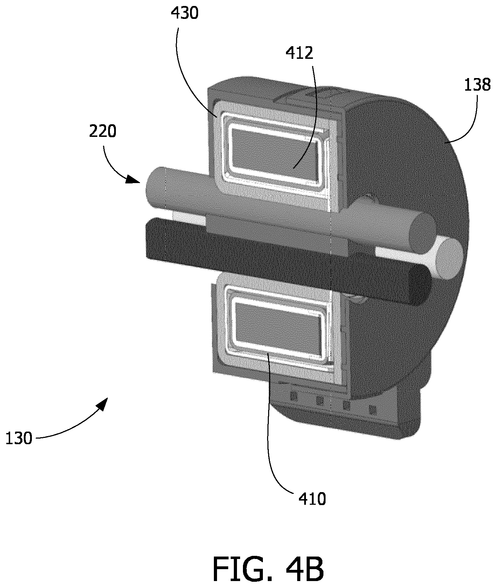

In certain embodiments, CT 130 of FIG. 1 includes one or more of a body 132, a first terminal 134 (e.g., having a plurality of pins extending downward), a second terminal 136 (e.g., having first, second, third, and fourth pins 136a, b, c, d, respectively), a housing 138, and/or an opening 140. In certain embodiments, the first terminal 134 and the second terminal 136 may include a plurality of pins in various embodiments. The first terminal 134 and the second terminal 136 may be connected together such that each pin 136a, b, c, d of second terminal 136 is connected to a respective pin of first terminal 134. In certain embodiments, the first pin 136a and the second pin 136b can be connected to opposing ends of a sense winding or coil 410 (see FIGS. 4A and 4B) contained within the housing 138 of CT 130. The opening 140 of CT 130 may be configured to permit one or more conductors 220 (see FIG. 2) and/or other conductor(s) or components (or portions thereof)) to pass at least partially therethrough. The CT 130 of FIG. 1 can include a shield 430 (see FIGS. 4A and 4B) in various embodiments as described herein.

In accordance with at least one aspect of this disclosure, referring to FIG. 2, a GFCI 210 includes conductors 220 (e.g., a line, neutral, or ground) passing through a current transformer, such as CT 130 disclosed herein. The conductors 220 pass through opening 140, for example. Any suitable number of conductors 220 for any suitable application are contemplated herein (e.g., three as shown). As described above, CT 130 includes a sense coil wrapped around a core 412 (see FIGS. 4A and 4B) of CT 130 configured to magnetically couple to the line conductor and the neutral conductor passing through opening 140. The GFCI 210 can include a test winding or coil wrapped (e.g., partially) around the core 412 of CT 130 and configured to magnetically couple to the sense coil through the core 412 to provide a test signal to the sense coil.

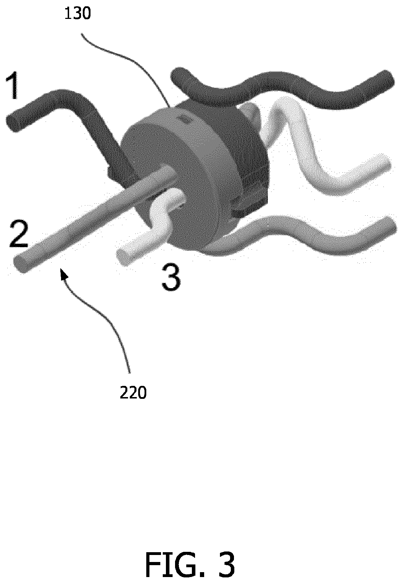

Referring now to FIG. 3, the electrical protective device (e.g., GFCI 210) includes a plurality of conductors 220 (e.g., a line, neutral, or ground). At least a portion of one or more of the conductors 220 is configured to pass through the opening 140 of CT 130. Although illustrated with three conductors 220, it should be appreciated that any number of conductors may be configured to pass through at least a portion of the opening 140 of CT 130 in various embodiments without departing from the spirit and scope of this disclosure.

FIG. 3 illustrates a partial depiction of an element of a sensor component (e.g., CT 130) having a plurality of current paths passing therethrough according to aspects of this disclosure. In the example of FIG. 3, current flows in L1 and L2, where I1=I2. FIG. 3 illustrates an example of CT 130 having non-uniform and random winding distribution and effect(s) from nearby conductors 220. If conductors 220 are installed in close proximity to CT 130 during assembly of the electrical protective device (as shown in the example of FIG. 3), the current in conductors 220 creates an electromagnetic pattern that can unbalance the output voltage during a loaded ground fault event (load current + ground fault). As a result, the sensor output voltage values of CT 130 at specific ground faults deviate from the calibrated ones. The effect of a random distribution of coils in combination with the magnetic influence of nearby conductors 220 (wrap around effect) results in an output voltage, Vout, that has a non-zero magnitude. Vout can have a considerably higher value compared to the ideal case (uniform winding distribution).

FIGS. 4A and 4B show current transformer 130 in accordance with at least one aspect of the present disclosure for use in GFCI 210. As shown in FIG. 4A, CT 130 has its cover removed to reveal its interior. The CT 130 can include a sense coil 410 wrapped around a core 412 configured to magnetically couple to a line conductor and a neutral conductor passing through the opening 140. The sense coil 410 is further configured to a generate a fault signal in response to a ground fault condition in the conductors 220. The core 412 in the illustrated embodiment has a passage through it corresponding to opening 140. The CT 130 can also include a test coil 414 partially wrapped around core 412 and configured to magnetically couple to the sense coil 410 through core 412 to provide a test signal to sense coil 410 in response to a test signal stimulus applied to the test coil 414. FIG. 4B further illustrates a metallic shield 430 to be described in greater detail below.

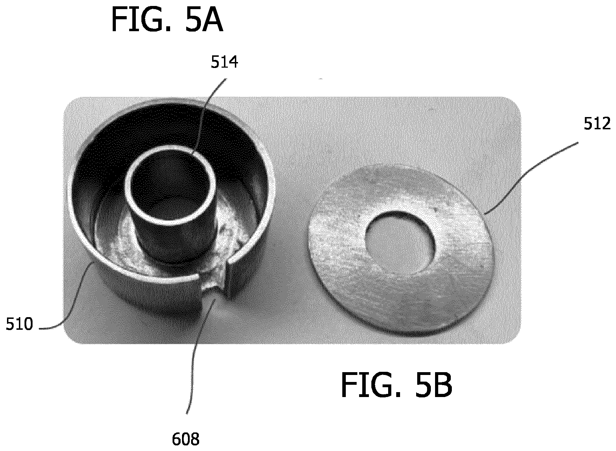

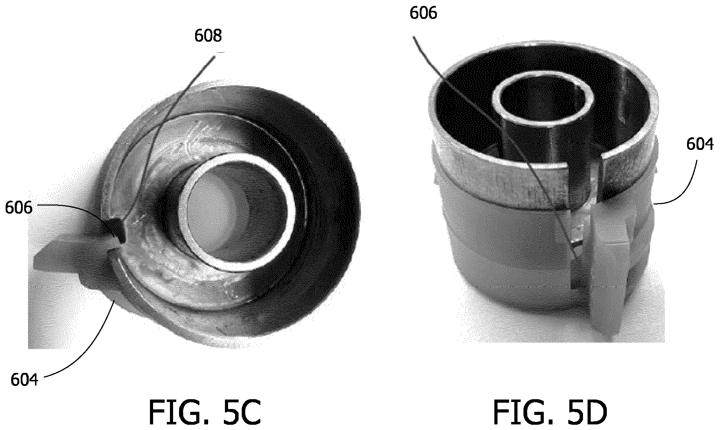

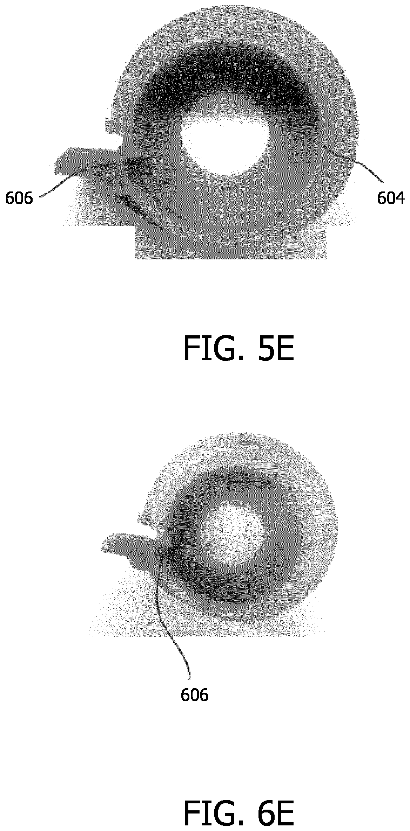

FIGS. 5A and 5B illustrate the magnetically permeable shield 430, which is configured to receive core 412 and the sense and test coils 410, 414. In an embodiment, the shield 430 is made from a ferromagnetic material (e.g., 1010 steel alloy, 1018 steel alloy). The shield 430 is configured to shield the core 412 from external magnetic field lines, such as those generated externally to CT 130 by currents in conductors 220. Nearby magnetic fields are absorbed by shield 430. Thus, flux lines do not cross to the wound core 412 thus avoiding deviation from the output voltage of CT 130. A differential sensor such as CT 130 equipped with shield 430 to reduce cross-talk electromagnetic effects of nearby conductors provides improved performance and reliability.

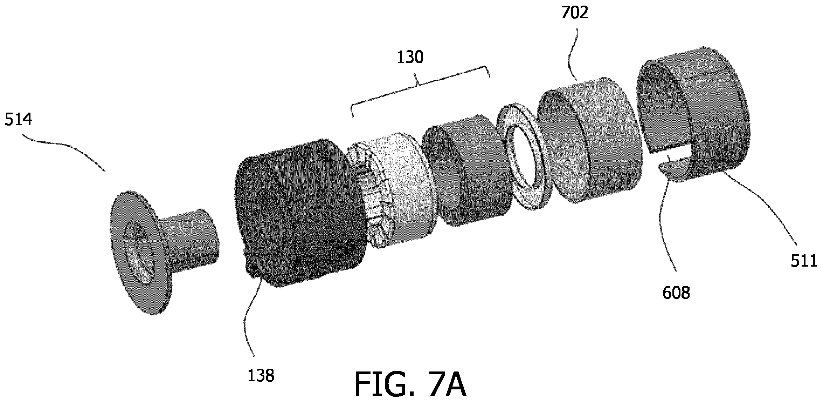

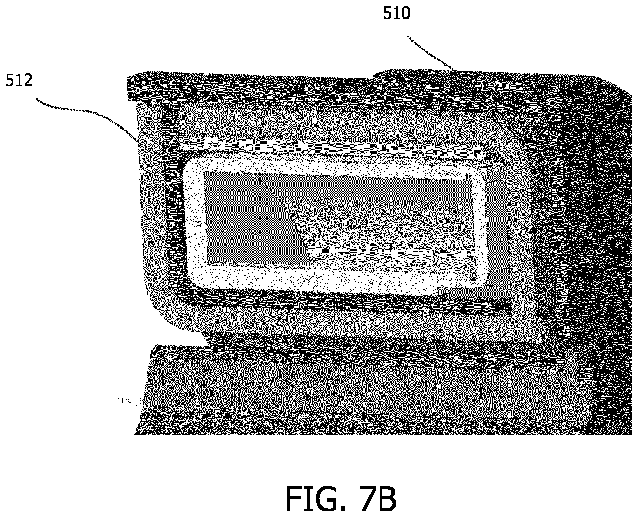

The shield 430 according to one or more embodiments comprises an outer portion and an inner portion located in an interior of the outer portion. The outer and inner portions of shield 430 define a space therebetween in which core 412, sense coil 410, and test coil 414 are received. In the illustrated embodiment, the outer portion of shield 430 comprises a cup-shaped shell 510 sized and shaped to receive core 412 and coils 410, 414 in FIG. 5A and a washer-shaped cap 512 for closing the shell 510 in FIG. 5B. The inner portion of shell 510 comprises an eyelet 514 such that the shell 510 and the eyelet 514 comprise an outer cylinder and a concentric inner cylinder, respectively. The core passage fits around the eyelet 514 when core 412 is received within the shield 430. In an embodiment, an insulator 702 (see FIG. 7) separates core 412 from the inner surface of shell 510. Advantageously, an improved performance of the sensor can be achieved by diverting the flux lines from the sensor core to the shield. This reduces cross-talk, which in turn reduces output voltage sensor variation and results in improved GF thresholds.

Referring now to FIGS. 5C to 5E, CT 130 further comprises a jacket 604 covering the shield 430. The jacket 604 includes a first locking feature 606 and the shield 430 comprises a second locking feature 608. The second locking features 606, 608 engage each other in a mating relationship to prevent shield 430 from rotating relative to jacket 604. In accordance with one or more embodiments of the present disclosure, the first locking feature 606 of jacket 604 comprises a projection and the second locking feature 608 of shield 430 comprises a slot, which is sized and shaped to receive the projection.

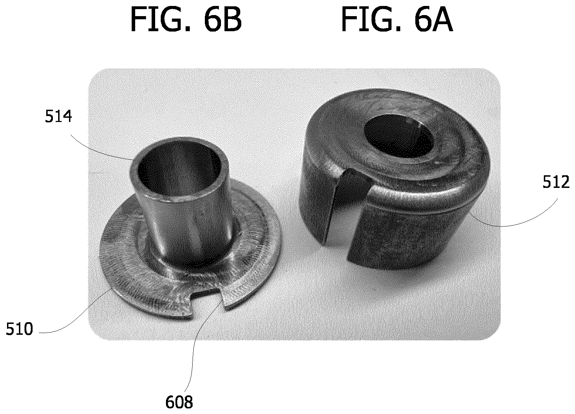

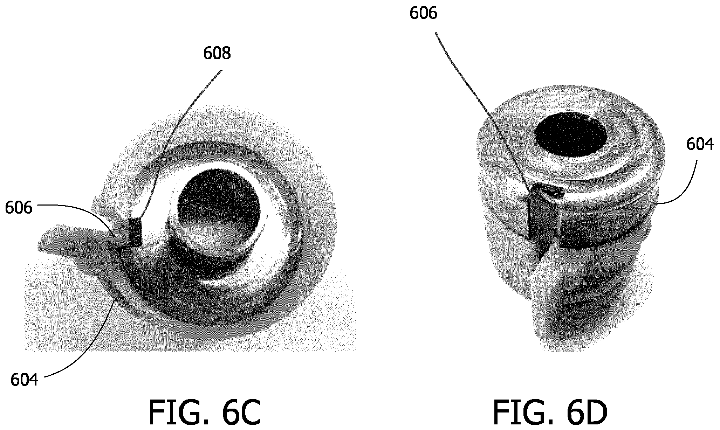

In an alternative embodiment, the outer portion of shield 430 comprises a cup-shaped shell 510 sized and shaped to receive core 412 and coils 410, 414 in FIG. 6A and a washer-shaped cap 512 for closing the shell 510 in FIG. 6B. In this embodiment, the inner portion of shield 430, i.e., the eyelet 514, is integrated the eyelet 514 is integrated the washer-shaped cap portion 512 rather than with shell 510. FIGS. 6C to 6E illustrate the jacket 604 covering the shield 430 of FIGS. 6A and 6B. The jacket 604 includes a first locking feature 606 and the shield 430 comprises a second locking feature 608. The second locking features 606, 608 engage each other in a mating relationship to prevent shield 430 from rotating relative to jacket 604. In accordance with one or more embodiments of the present disclosure, the first locking feature 606 of jacket 604 comprises a projection and the second locking feature 608 of shield 430 comprises a slot, which is sized and shaped to receive the projection.

FIGS. 7A and 7B illustrate a current transformer assembly according to another alternative embodiment in which the eyelet 514 is integrated with washer cap 512 rather than with shell 510.

Aspects of the present disclosure provide shield 430 is designed as a shell 510 configured to receive the wound core 412, insulated between the wound core and metallic shield 430 by an insulator 702 (e.g., a plastic shell).

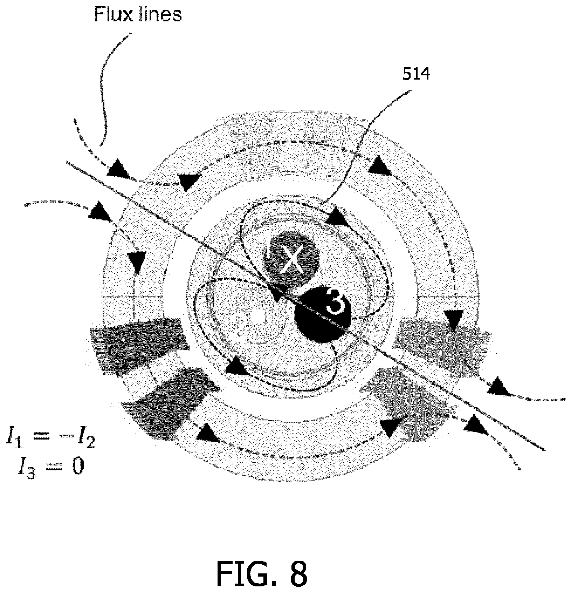

The eyelet 514 advantageously smooths the specific magnetic flux pattern as shown in the schematic diagram of FIG. 8. The eyelet 514 of shield 430 directs the flux lines around the eyelet core before crossing to the core 412.

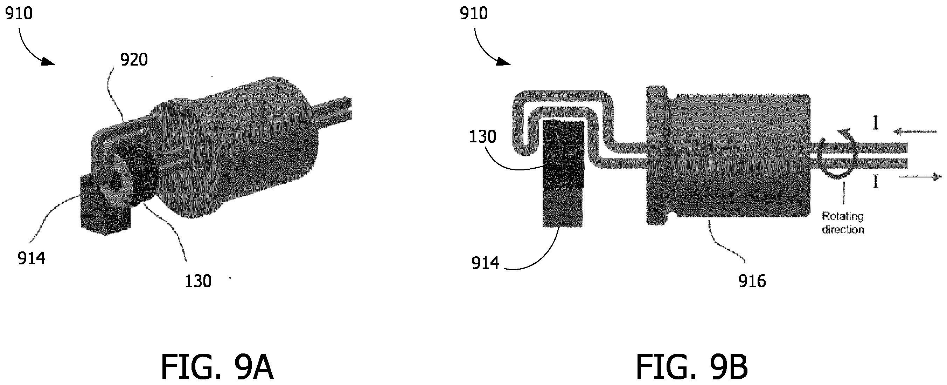

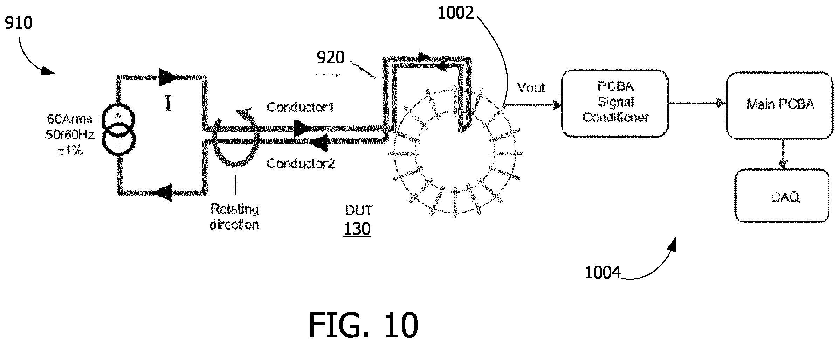

There are complex challenges on how to properly screen a sensor to accurately recreate environmental conditions (e.g., MCB current path assembly). In accordance with at least one aspect of the present disclosure, referring now to FIGS. 9A and 9B, a system 910 for screening a device under test 912 (DUT) for cross-talk is shown. The system 910 includes a mounting fixture, or nest, 914 having at least one terminal 1002 (see FIG. 10). The nest 914 is configured for coupling to the DUT 912, such as CT 130, via the terminal 1002 and receiving an output signal Vout during screening. The system 910 also includes a rotatable support 916 to which an external conductor 918 is attached. The external conductor 918 represents a "generic" current path in near proximity to DUT 912 and forms a loop 920 having a U-shape and sized such that loop 920 is free to rotate about DUT 912 without contact. The loop 920 is configured to be positioned in proximity to DUT 912 when DUT 912 is connected to nest 914 while the rotatable support 916 rotates loop 920 through a plurality of radial positions during screening. When external conductor 918 is energized, current in the loop 920 generates a magnetic field near DUT 912.

Referring now to FIG. 10, a test module 1004 coupled to nest 914 receives the output signal Vout during screening. The test module 1004 comprises a data acquisition device receiving and responsive to the output signals for obtaining and processing measurement data at each of a plurality of radial positions of the rotatable loop 920. In an embodiment, test module 1004 also includes signal conditioning circuitry for amplifying and conditioning the output signals. In turn, test module compares the output signal of DUT 912 when the external conductor 918 is not energized to the output signal of DUT 912 when the external conductor 918 is energized. Based on this comparison, test module 1004 screens DUT 912 for a susceptibility to magnetic wrap-up effects and outputs, for example, a pass or fail signal. Advantageously, the test system 910 enables the testing of the effectiveness of a protective shield around a wound core, such as shield 430 around core 412.

In an embodiment, system 910 is combined with a winding distribution test apparatus, such as disclosed in commonly assigned U.S. Patent Application No. 18/539,141. The winding distribution test apparatus comprising a probe configured for housing at least a portion of the one or more conductors 220, wherein the nest 914 permits at least a portion of the probe to pass through the core opening 140. Multiple tests can be combined: winding distribution, output voltage, and cross-talk. A combination of several tests in the same fixture optimizes testing time.

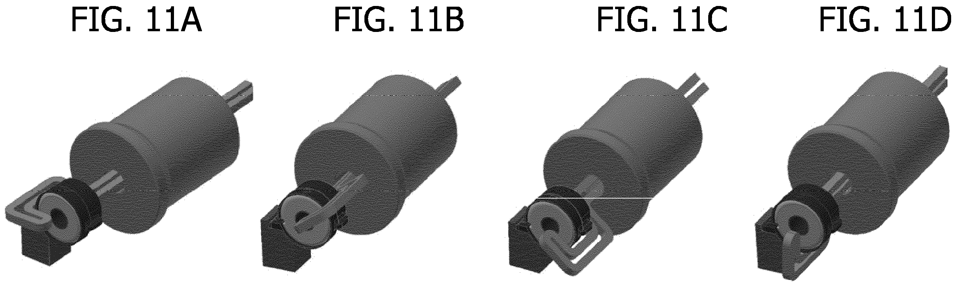

FIGS. 11A to 11D illustrate a sequence of testing DUT 912 through a plurality of radial positions in accordance with one or more embodiments.

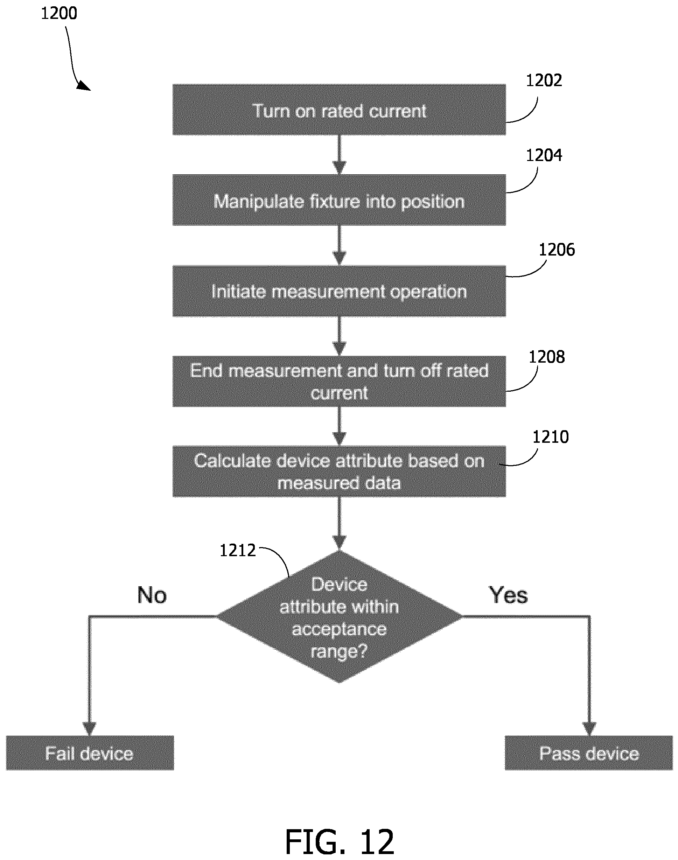

Aspects of the present disclosure perform a method of screening DUT 912. FIG. 12 illustrates an example process 1200 for screening DUT 912. Beginning at 1202, external conductor 918 is energized at rated current. At 1204, DUT 912 is positioned relative to rotatable external conductor 918, which is formed into loop 920 in proximity to DUT 912. As described above, current in the loop 920 generates a magnetic field in proximity to DUT 912. The method further includes rotating external conductor 918 relative to DUT 912 through a plurality of radial positions and obtaining subsequent output signals from DUT 912 at the plurality of radial positions. Step 1206 refers to the measurement operation of process 1200, after which external conductor 918 is deenergized at 1208. The test module 1004 calculates device attributes based on the measure data at 1210. For example, test module 1004 compares the initial output signal of DUT 912 when the external conductor 918 is not energized to the subsequent output signals of DUT 912 when the external conductor 918 is energized and determines a susceptibility of DUT 912 to magnetic wrap-up effects based on the comparison. In addition, a pass signal or a fail signal may be generated based on comparing the subsequent output signals to a predetermined range of acceptable values at 1212.

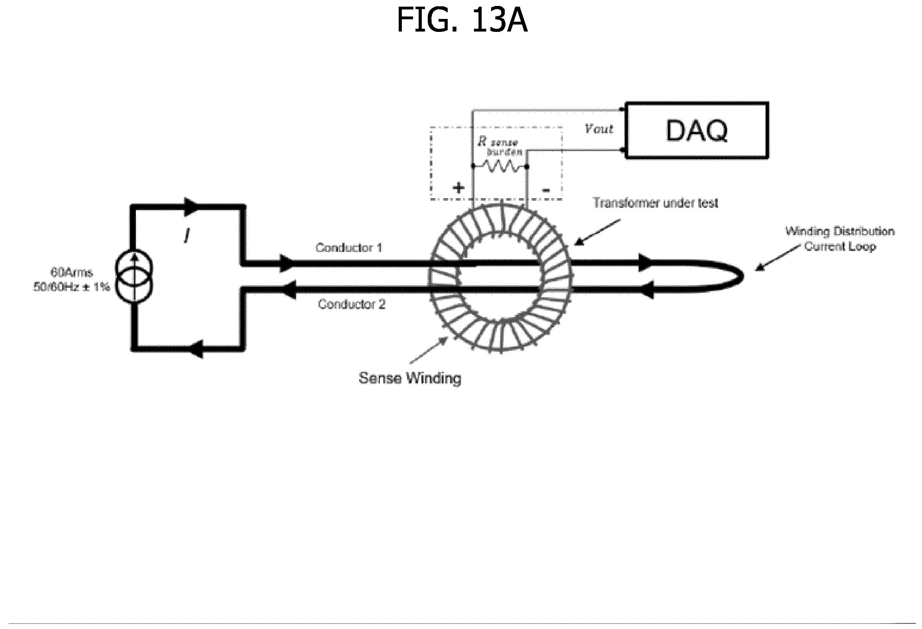

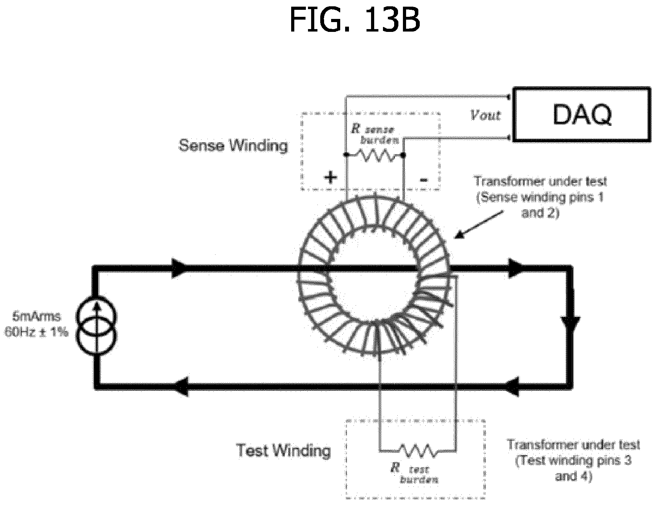

FIGS. 13A and 13B are schematic diagrams of exemplary test setups in accordance with embodiments of the present disclosure.

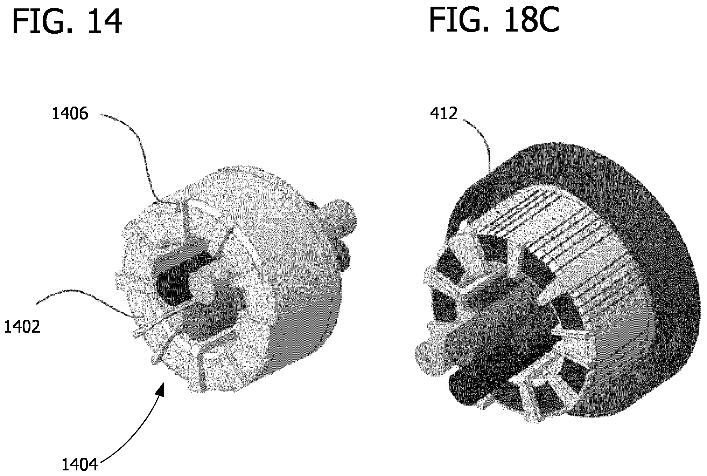

A proper winding pitch and symmetry is difficult to maintain and control around a closed-core differential sensor. Referring now to FIG. 14, aspects of the present disclosure relate to an assembly guide to solve winding distribution issues on differential current transformers by adding specific grooves on a unique plastic shell. A better winding distribution enhances the sensor performance. The assembly guide of FIG. 14 comprises a shell 1402 that is sized and shaped to receive core 412 of CT 130. As shown, the shell 1402 has a plurality of grooves 1404 formed in its outer surface. In the illustrated embodiment, the grooves 1404 are formed in a top, or end, surface of shell 1402. The grooves 1404 are spaced apart in accordance with a predetermined winding distribution pattern such that portions of sense winding 410 wrapped around core 412 and shell 1402 are positioned in selected grooves 1404 in accordance with the predetermined winding distribution pattern. Similarly, the grooves 1404 are spaced apart in accordance with the predetermined winding distribution pattern such that portions of test winding 414 wrapped around core 412 and shell 1402 are positioned in other selected grooves 1404 of the shell in accordance with the predetermined winding distribution pattern. In this manner, the assembly guide reduces winding distribution inconsistencies by fixing the coils pattern, which improves ground fault thresholds.

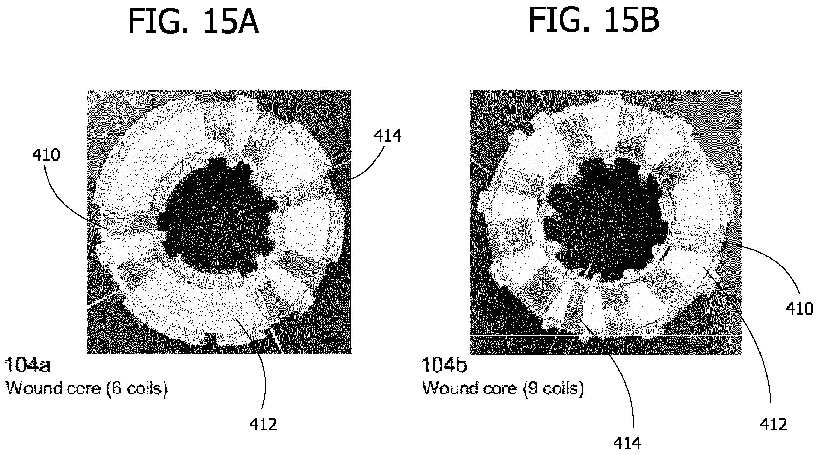

FIGS. 15A and 15B are two example cores 412 having windings 410, 414 wound thereon in accordance with predetermined winding distribution patterns. A specific magnetic flux pattern around the toroid core is characterized by closed loops of field lines that completely encircle the core, essentially forming concentric circles perpendicular to the direction of the current flowing through the windings, with the flux concentrated primarily within the core itself due to the toroid's symmetrical design, minimizing leakage flux outside the ring. To achieve a balanced magnetic pattern, a geometrical positioning of the conductors is required. Furthermore, by positioning the coils in groups near the zones with high flux density, a balanced output voltage from the sensor can be achieved.

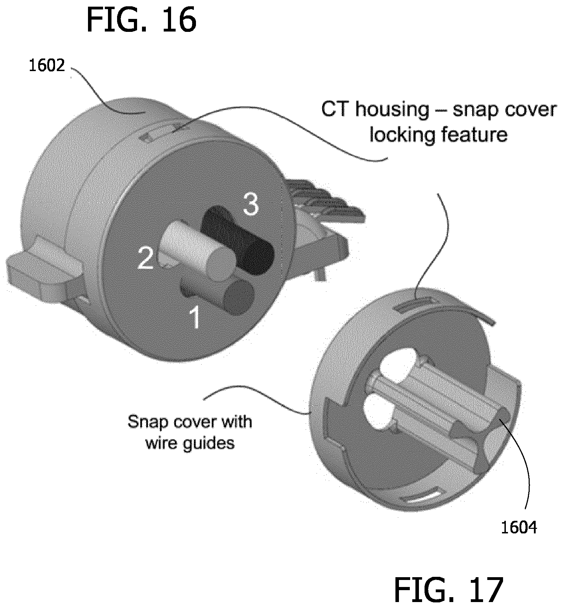

Referring now to FIG. 16, aspects of the present disclosure relate to another assembly guide for a current transformer for use instead of or in addition to the assembly guide of FIG. 14. According to this embodiment, the assembly guide comprises a housing 1602 in which core 412, shell 1402, and windings 410, 414 are contained. The housing 1602 comprises two pieces that engage each other in a snap-fit relationship. One of the pieces of the housing 1602 comprises a prong 1604 extending axially as shown in FIG. 17. The prong 1604 is sized and shaped to fit in the core opening 140 and is configured for receiving the conductors 220 and maintaining the received conductors in predetermined positions within the core opening 140 to control the magnetic field pattern by positioning current conductors in specific locations. In an embodiment, prong 1604 is Y-shaped and configured to receive three conductors 220.

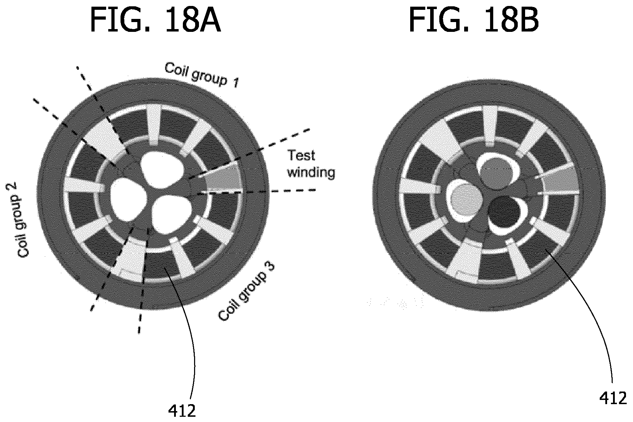

FIG. 18A illustrates a wound core 412 positioned on prong 1604. FIG. 18B similarly illustrates wound core 412 positioned on prong 1604 in addition to conductors 220 passing through the opening 140 and received in channels defined by prong 1604. FIG. 18C is a perspective view of the partial current transformer assembly of FIG. 18B. A differential current transformer (e.g., ground fault CT for MCBs) designed with a specific winding pattern reduces winding distribution unbalances.

In an embodiment, shell 1402 comprises a first locking feature and housing 1602 comprises a second locking feature that engage each other in a mating relationship to prevent shell 1402 and core 412 from rotating relative to housing 1602. The use of locking features between the wound core 412, shield 430 (if used), and snap cover housing 1602 promotes repeatable assembly. For example, the first locking feature of the shell comprises a projection 1406 as shown in FIG. 14 and the second locking feature of the housing comprises a slot (not shown; similar to second locking feature 608 of shield 430) that is sized and shaped to receive the projection 1406. The shell 402 is further configured for use with an industrial winding machine.

Embodiments of the present disclosure may comprise a special purpose computer including a variety of computer hardware, as described in greater detail herein.

For purposes of illustration, programs and other executable program components may be shown as discrete blocks. It is recognized, however, that such programs and components reside at various times in different storage components of a computing device, and are executed by a data processor(s) of the device.

Although described in connection with an example computing system environment, embodiments of the aspects of the invention are operational with other special purpose computing system environments or configurations. The computing system environment is not intended to suggest any limitation as to the scope of use or functionality of any aspect of the invention. Moreover, the computing system environment should not be interpreted as having any dependency or requirement relating to any one or combination of components illustrated in the example operating environment. Examples of computing systems, environments, and/or configurations that may be suitable for use with aspects of the invention include, but are not limited to, personal computers, server computers, hand-held or laptop devices, multiprocessor systems, microprocessor-based systems, set top boxes, programmable consumer electronics, mobile telephones, network PCs, minicomputers, mainframe computers, distributed computing environments that include any of the above systems or devices, and the like.

Embodiments of the aspects of the present disclosure may be described in the general context of data and/or processor-executable instructions, such as program modules, stored one or more tangible, non-transitory storage media and executed by one or more processors or other devices. Generally, program modules include, but are not limited to, routines, programs, objects, components, and data structures that perform particular tasks or implement particular abstract data types. Aspects of the present disclosure may also be practiced in distributed computing environments where tasks are performed by remote processing devices that are linked through a communications network. In a distributed computing environment, program modules may be located in both local and remote storage media including memory storage devices.

In operation, processors, computers and/or servers may execute the processor-executable instructions (e.g., software, firmware, and/or hardware) such as those illustrated herein to implement aspects of the invention.

Embodiments may be implemented with processor-executable instructions. The processor-executable instructions may be organized into one or more processor-executable components or modules on a tangible processor readable storage medium. Also, embodiments may be implemented with any number and organization of such components or modules. For example, aspects of the present disclosure are not limited to the specific processor-executable instructions or the specific components or modules illustrated in the figures and described herein. Other embodiments may include different processor-executable instructions or components having more or less functionality than illustrated and described herein.

The order of execution or performance of the operations in accordance with aspects of the present disclosure illustrated and described herein is not essential, unless otherwise specified. That is, the operations may be performed in any order, unless otherwise specified, and embodiments may include additional or fewer operations than those disclosed herein. For example, it is contemplated that executing or performing a particular operation before, contemporaneously with, or after another operation is within the scope of the invention.

When introducing elements of the invention or embodiments thereof, the articles "a," "an," "the," and "said" are intended to mean that there are one or more of the elements. The terms "comprising," "including," and "having" are intended to be inclusive and mean that there may be additional elements other than the listed elements.

Not all of the depicted components illustrated or described may be required. In addition, some implementations and embodiments may include additional components. Variations in the arrangement and type of the components may be made without departing from the spirit or scope of the claims as set forth herein. Additional, different or fewer components may be provided and components may be combined. Alternatively, or in addition, a component may be implemented by several components.

The above description illustrates embodiments by way of example and not by way of limitation. This description enables one skilled in the art to make and use aspects of the invention, and describes several embodiments, adaptations, variations, alternatives and uses of the aspects of the invention, including what is presently believed to be the best mode of carrying out the aspects of the invention. Additionally, it is to be understood that the aspects of the invention are not limited in its application to the details of construction and the arrangement of components set forth in the following description or illustrated in the drawings. The aspects of the invention are capable of other embodiments and of being practiced or carried out in various ways. Also, it will be understood that the phraseology and terminology used herein is for the purpose of description and should not be regarded as limiting.

It will be apparent that modifications and variations are possible without departing from the scope of the invention defined in the appended claims. As various changes could be made in the above constructions and methods without departing from the scope of the invention, it is intended that all matter contained in the above description and shown in the accompanying drawings shall be interpreted as illustrative and not in a limiting sense.

In view of the above, it will be seen that several advantages of the aspects of the invention are achieved and other advantageous results attained.

The Abstract and Summary are provided to help the reader quickly ascertain the nature of the technical disclosure. They are submitted with the understanding that they will not be used to interpret or limit the scope or meaning of the claims. The Summary is provided to introduce a selection of concepts in simplified form that are further described in the Detailed Description. The Summary is not intended to identify key features or essential features of the claimed subject matter, nor is it intended to be used as an aid in determining the claimed subject matter.

## Claims

1. A shielded current transformer comprising:
a core having a passage therethrough configured to receive one or more conductors;
a sense winding wound around the core, the sense winding configured to magnetically couple to the conductors passing through the core passage, the sense winding further configured to a generate a fault signal in response to a ground fault condition in the conductors;
a test winding wound around the core, the test winding configured to generate a test signal in response to a test signal stimulus applied thereto such that the test signal is magnetically coupled to the sense winding; and
a magnetically permeable shield receiving the core and the windings therein and configured to shield the core from magnetic field lines generated external to the shield.

2. A shield for a current transformer, the shield comprising:
a magnetically permeable cup-shaped shell sized and shaped to receive a core and windings of a current transformer; and
a magnetically permeable washer-shaped cap for closing the cup-shaped shell.

3. The shield of claim 2, wherein the shell comprises an outer cylinder, and further comprising a concentric inner cylinder located in an interior of the shell,
wherein the concentric inner cylinder is in particular mounted on the washer-shaped cap.

4. The shield of claim 3, wherein the outer and inner cylinders define a space therebetween in which the core and windings of the current transformer are received.

5. The shield of claim 3 or 4, wherein the concentric inner cylinder mounted on an inner bottom surface of the cup-shaped shell.

6. The shield of claim 2, wherein a jacket covering the shell, the core, and the windings comprises a first locking feature and the shell comprises a second locking feature, the first and second locking features engaging each other in a mating relationship to prevent the shell and core from rotating relative to the jacket.

7. The shield of claim 6, wherein the first locking feature of the jacket comprises a projection and the second locking feature of the shell comprises a slot sized and shaped to receive the projection.

8. An electrical protective device comprising:
a line conductor;
a neutral conductor; and
a current transformer, the current transformer comprising:
a core having a passage therethrough configured to receive the line conductor and the neutral conductor;
a sense winding wound around the core, the sense winding configured to magnetically couple to the line conductor and the neutral conductor passing through the core passage, the sense winding further configured to a generate a fault signal in response to a line-to-ground fault condition;
a test winding wound around the core, the test winding configured to generate a test signal in response to a test signal stimulus applied thereto such that the test signal is magnetically coupled to the sense winding; and
a magnetically permeable shield receiving the core and the windings therein and configured to shield the core from magnetic field lines generated external to the shield.

9. The device of any one of the preceding claims, wherein the shield comprises an outer portion and an inner portion located in an interior of the outer portion, the outer and inner portions of the shield defining a space therebetween in which the core and the windings are received.

10. The device of claim 9, wherein the outer portion of the shield comprises an outer cylinder and the inner portion of the shield comprises a concentric inner cylinder.

11. The device of claim 3 or 9, wherein the core passage fits around the inner portion of the shield when the core is positioned within the shield.

12. The device of claim 9, wherein the outer portion of the shield is closed at each end except for an opening at each end of the inner portion of the shield, or
wherein the outer portion of the shield comprises:
a cup-shaped shell sized and shaped to receive the core and the windings; and
a washer-shaped cap for closing the cup-shaped shell,
wherein the inner portion of the shield in particular comprises a concentric inner cylinder mounted on the washer-shaped cap and configured to project into an interior of the cup-shaped shell and fit in the core passage when the core is positioned within the shell, or
wherein the inner portion of the shield comprises a concentric inner cylinder mounted on an inner bottom surface of the cup-shaped shell and configured to project into an interior of the cup-shaped shell and fit in the core passage when the core is positioned within the shell.

13. The device of claim 9, further comprising an insulator between the core and an inner surface of the outer portion of the shield.

14. The device of any one of the preceding claims, further comprising a jacket covering the shield, the core, and the windings.

15. The device of claim 14, wherein the jacket comprises a first locking feature and the shield comprises a second locking feature, the first and second locking features engaging each other in a mating relationship to prevent the shield from rotating relative to the jacket,
wherein in particular the first locking feature of the jacket comprises a projection and the second locking feature of the shield comprises a slot sized and shaped to receive the projection.
